Europäisches Patentamt

European Patent Office

Office européen des brevets

(19)

(11) Veröffentlichungsnummer : **0 200 773**
**B1**

(12) **EUROPÄISCHE PATENTSCHRIFT**

(45) Veröffentlichungstag der Patentschrift :
**17.05.89**

(21) Anmeldenummer : **85905774.7**

(22) Anmeldetag : **18.11.85**

(86) Internationale Anmeldenummer :
**PCT/DE 85/00473**

(87) Internationale Veröffentlichungsnummer :
**WO/8603056 (22.05.86 Gazette 86/11)**

(51) Int. Cl.⁴ : **H 01 L 23/26**

(54) **VERFAHREN ZUR VERKAPSELUNG VON MIKROELEKTRONIKSCHALTUNGEN MIT ORGANISCHEN KOMPONEN-TEN.**

(30) Priorität : **17.11.84 DE 3442132**

(43) Veröffentlichungstag der Anmeldung :
**12.11.86 Patentblatt 86/46**

(45) Bekanntmachung des Hinweises auf die Patenter-teilung : **17.05.89 Patentblatt 89/20**

(84) Benannte Vertragsstaaten :
**FR GB IT**

(56) Entgegenhaltungen :
**FR-A- 1 448 423**
**GB-A- 873 916**
**GB-A- 1 193 610**
**Chemical Abstracts, vol. 99, 1983, Columbus, Ohio (US), Chen et al.: "The vacuum high-speed melted barium-aluminum alloy (BaAl4) and its properties", p. 263, abstract 144293q**

(73) Patentinhaber : **Messerschmitt-Bölkow-Blohm Gesell-schaft mit beschränkter Haftung**
**Robert-Koch-Strasse**
**D-8012 Ottobrunn (DE)**

(72) Erfinder : **MÖLLER, Werner**
**Ravensburger Strasse 77**
**D-7900 Ulm (DE)**

EP 0 200 773 B1

## EP 0 200 773 B1

**Beschreibung**

Die Erfindung betrifft ein Verfahren zur Verkapselung von Mikroelektronik-Schaltungen mit organischen Komponenten, bei dem zur Aufnahme von korrodierenden Gasen im Innenraum als Getter feinstkörniges Pulver in einem gasdurchlässigen, inerten Silikonkautschuk dispergiert wird.

Aufgrund der an derartige Elemente zu stellenden praktischen Anforderungen werden hochzuverlässige elektronische Schaltungen überdies durch hermetisches Verschweißen oder Verlöten mit einem Metall- oder Keramikgehäuse gegen Umwelteinflüsse, Feuchtigkeit, $CO_2$, $SO_2$ u. a. korrosive Stoffe geschützt. Andererseits werden mehr und mehr organische Stoffe zum Passivieren, Die-Bonden und als Abdeckung gegen mechanische Schocks beim Aufbau der Elektronik-Schaltungen eingesetzt. Jedoch muß bei thermischer Belastung, wie sie in Leistungshybriden und z. T. in geringerem Umfang bei Kleinsignalschaltkreisen auftritt, auch bei in der Mikroelektronik bewährten thermisch stabilen Epoxid-, Polyurethan- und Silikonharzen bzw. Elastomeren mit einer geringen Gasbildung gerechnet werden. Es handelt sich dabei aufgrund von Gasanalysen zumeist um $H_2O$, $CO_2$, CO, $NH_3$ und organische Säuren, die bei Leistungshybriden unter Spannung nicht nur an Aluminium-Leiterbahnen und -Bonddrähten zur elektrolytischen Korrosion und damit zum Ausfall der Schaltungen führen. Der hierbei entstehende Wasserstoff sowie Restsauerstoff verstärken die Korrosion, so daß diese Gase entfernt werden sollten.

Bei Kleinleistungshybriden schlagen sich die Gase teilweise als Feuchte nieder und verursachen zusätzlich unter Spannung Elektrolyse. Die Alterungs- bzw. Spaltprodukte lassen sich trotz eingehender Bemühungen verfahrenstechnisch, z. B. Evakuieren, $N_2$-Spülung, Trocknung nur bedingt verhindern. Die in der Elektronik verwendeten z. B. aus der DE-OS 31 12 564 bekannten Trockenmittel, oder die Molekularsiebe auf Zeolith-Basis, deren Anwendung z. B. aus EP-A1 0 113 282 bekannt ist, absorbieren nur die Feuchtigkeit und geben sie beim Erwärmen, d. h. unter kritischen Schaltungsbedingungen, wieder ab.

Es ist beispielsweise aus der FR-A 1 448 423, aus der GB-PS 1 193 610 oder der CH-PS 445 648 bekannt, pulverförmige Gettermaterialien, z. B. Erdalkalioxide in Silikonkautschuk bei elektronischen Bauteilen zu verwenden. Diese reagieren aber nur bedingt mit korrosiven Gasen wie $NH_3$, $CO_2$ und $H_2O$.

Die Verwendungsmöglichkeit von Legierungen als Gettermaterialien ist beispielsweise Römpp's Chemielexikon, 7. Auflage (1973), Seite 1275 zu entnehmen. Aus der US-PS 3 007 089 ist es bekannt, in Transistorgehäusen metallische Gettermaterialien unterzubringen; diese sind aber in einer kompakten Schicht mit entsprechend geringer aktiver Oberfläche eingebracht. Das gleiche gilt für die Quecksilber-Aluminium-Verbindung nach der DE-AS 1 057 694.

Ferner wird z. B. in der EP-A2 0 025 647 vorgeschlagen, teilweise vernetzten Silikonkautschuk allein als Getter bzw. Staubfänger für Staubpartikel zu verwenden, der selbstverständlich nicht als Gasgetter wirkt und Feuchtigkeit nicht absorbiert.

Geeigneter sind hochaktive Gettermaterialien, die durch Verdampfen oberflächenreich verteilt werden und alle reaktiven Gase irreversibel abfangen, ggf. das Vakuum stabil halten und eine Gasreaktion verhindern.

Derartige hochaktive Getter wurden für Elektronenstrahlröhren zur Absorption von korrosiven Gasen und von Feuchtigkeitsspuren entwickelt. Bevorzugt verwendet man hierfür Erdalkali- und Zirkonmetall- und Zirkonhydrid-Stangen, die verdampft werden und sich in der Wärme entsprechend dem Barium in folgenden Reaktionen mit den entstehenden Spaltgasen mehr oder weniger stark umsetzen.

$$2\,Ba + H_2O \quad = Ba\,H_2 \quad + Ba\,O$$
$$5\,Ba + 2\,CO_2 \quad = Ba\,C_2 \quad + 4\,Ba\,O$$
$$3\,Ba + CO \quad = Ba\,C_2 \quad + 2\,Ba\,O$$
$$2\,Ba + 2\,NH_3 \quad = Ba\,H_2 \quad + Ba\,(NH_2)_2$$
$$2\,Ba + 2\,R{-}COOH \quad = Ba\,(R{-}COO)_2 \quad + Ba\,H_2$$
$$Ba + H_2 \quad = Ba\,H_2$$

Auch für die in Elektronik-Schaltungen verwendeten organischen Stoffe bzw. entstehenden Spaltgase erscheinen zunächst feinstkörnige $Ba\,Al_4$ Getter besonders geeignet, weil sie gegenüber Kovar bzw. Chromnickelstahl indifferent und gegenüber Stickstoff relativ stabil sind, aber alle übrigen Gase absorbieren bzw. chemisorbieren. Allerdings ist ein Verdampfen des Getters in Kleingehäusen schwierig.

Es ist das Ziel der Erfindung, Verfahren und zu ihrer Durchführung geeignete Materialien zu schaffen, die es ermöglichen, auch bei kleinen, einzukapselnden Elektronik-Schaltungen zuverlässig die korrodierenden Gase und störende Feuchtigkeit mit einem besonders aktiven Getter unschädlich zu machen und dabei unerwünschte Reaktionen mit den in solchen Schaltungen verwendeten Materialien zu vermeiden.

Gemäß der Erfindung wird dies dadurch erreicht, daß als Gettermaterial eine reaktive Erdalkalimetall-Aluminium-Legierung verwendet wird.

Die Lösung der gestellten Aufgabe besteht also darin, hochaktive, aber unkritisch verarbeitbare Getter in feinster Verteilung in einem gasdurchlässigen, indifferenten (gegenüber Getter, Gas und Schaltung), hochreinen Träger zu dispergieren. Untersuchungen ergaben, daß Barium-Aluminium-Legierungen einerseits und dünnflüssige, sehr reine, thermisch beständige, schwach additionsvernetzende Zweikomponenten-Silikongele andererseits diesen Anforderungen genügen und sich beliebig mischen lassen. Differentialthermoanalytisch (DSC2) ließ sich keine Reaktion nachweisen, wenn keine Feuchtigkeit einwirken konnte. Erst in der Wärme setzt eine langsame, durch die Diffusionsgeschwindigkeit bestimmte Reaktion ein, so daß erst beim Einschweißen und im Betrieb das Getter aktiviert wird.

Einzelheiten der Erfindung ergeben sich aus den Unteransprüchen und aus der Beschreibung, in der anhand der Figur ein Ausführungsbeispiel erläutert wird.

Es zeigen

Fig. 1a bis d den Aufbau von verschiedenen Formen der nach dem erfindungsgemäßen Verfahren eingekapselten Schaltungen.

Fig. 2 ein differentialthermoanalytisches Diagramm für Silikon-Gel ohne Gettermaterial.

Fig. 3 ein differentialthermoanalytisches Diagramm für Silikon-Gel mit $BaAl_4$ an Luft.

Fig. 4 ein differentialthermoanalytisches Diagramm für Silikon-Gel mit $BaAl_4$ an Luft mit Feuchtigkeit.

Fig. 5 ein differentialthermoanalytisches Diagramm für Silikon-Gel mit $BaAl_4$ in angefeuchteter Umgebung.

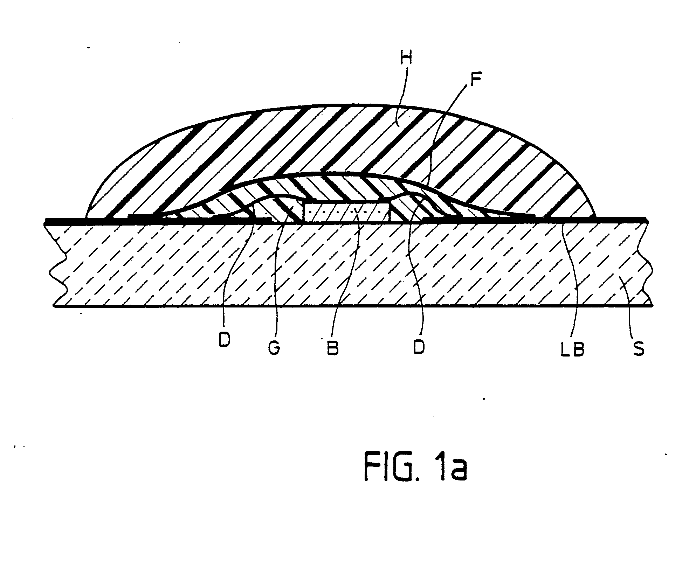

Die Fig. 1a bis 1d zeigen den grundsätzlichen Aufbau einer nach dem erfindungsgemäßen Verfahren eingekapselten Schaltung. Bei Fig. 1a haftet auf einem Substrat S, das zweckmäßig aus $Al_2O_3$ besteht, ein beispielsweise mit $Si_3N_4$ passivierter mikroelektronischer Baustein B, der in bekannter Weise mit Bonddrähten D, die aus Gold oder anderem hochleitfähigem Metall bestehen, mit den Leiterbahnen LB elektrisch verbunden ist. Der Baustein B und die Bonddrähte befinden sich innerhalb einer weichen Kunststoffschicht G, die aus Silikon-Gel mit $BaAl_4$-Füllung besteht. Diese ist mit einer Folie F abgedeckt, die eine Metallschicht enthält. Schließlich ist das Ganze mit Epoxidharz H mit $SiO_2$-Füllung eingekapselt.

Die weiche Kunststoffschicht G dient einerseits zur mechanischen Polsterung der Bausteine und Bond-Drähte, andererseits aber auch als Träger für das Gettermaterial. Aus diesem Grunde besteht sie aus einem Stoff der eingangs beschriebenen und in den Ausführungsbeispielen näher spezifizierten Art.

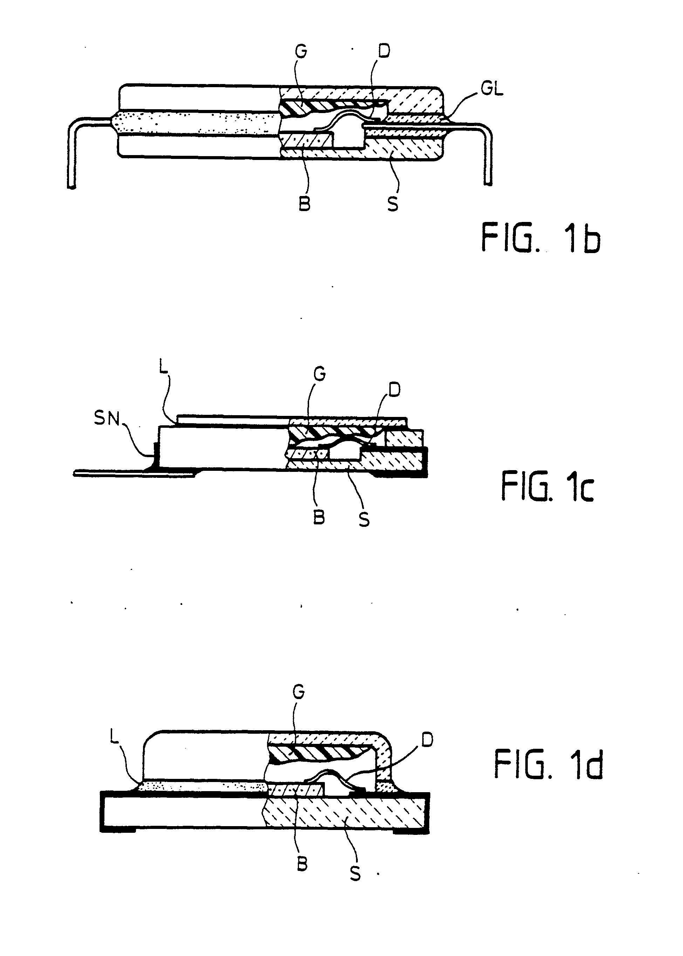

Es versteht sich, daß das erfindungsgemäße Verfahren auch bei Gehäusen aus starrem Material verwendet werden kann (Fig. 1b bis 1d).

Die Fig. 1a bis 1d zeigen bekannte Aufbauten mit starren Gehäusen. Dabei handelt es sich nach Fig. 1b um ein weit verbreitetes Plastik- bzw. Keramikgehäuse und bei den Ausführungsformen nach den Fig. 1c bis 1d um Metall- bzw. Keramikgehäuse. Die beiden Hälften des Gehäuses nach Fig. 1b sind beispielsweise mit Glas GL verbunden. Die Gehäuse nach Fig. 1c und 1d sind verschweißt bzw. verlötet ; die Schweißnähte sind mit SN und die Lötstellen mit L bezeichnet. Allen diesen Aufbauten ist gemeinsam, daß der an sich vorhandene leere Innenraum mit dem erfindungsgemäßen Gettermaterial wenigstens teilweise gefüllt ist.

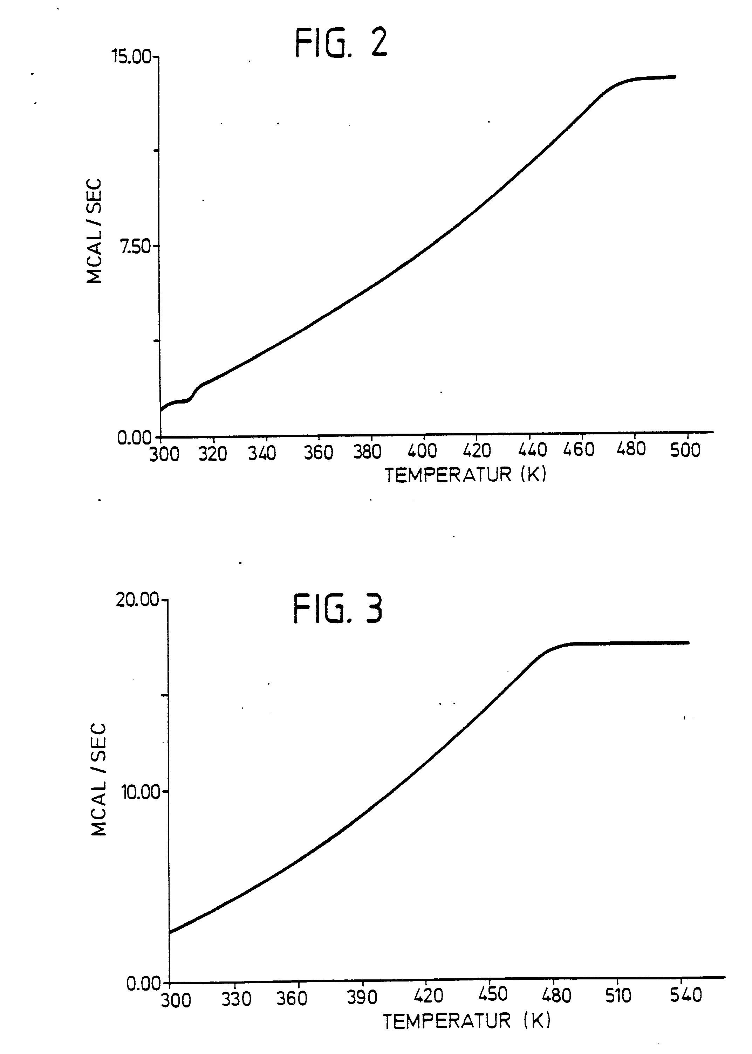

Die Figuren 2 bis 4 zeigen differentialthermoanalytische Diagramme für Silikon-Gel als Trägermaterial und $BaAl_4$ als Gettermaterial. Sämtliche Thermoanalysen sind bei $\Delta T/\Delta t$ = Konst und vergleichbaren Probenmengen und Bedingungen erstellt.

Bezüglich der Interpretation der Diagramme ist auszuführen, daß die vertikale Achse die Wärmetönung in mcal/sec darstellt. Auf der Abszisse sind Temperaturen in °K eingetragen. Eine linear verlaufende Kurve bedeutet, daß der Wärmefluß konstant ist und keine Reaktions- oder Umwandlungswärme auftritt, Durchhänge bedeuten, daß in diesem Bereich Wärme frei wird, z. B. durch Reaktion des Getters mit der Feuchte.

Fig. 2 zeigt ein differentialthermoanalytisches Diagramm für Silikon-Gel ohne Gettermaterial. Eine Wärmetönung ist nicht erkennbar.

Fig. 3 zeigt ein differentialthermoanalytisches Diagramm für Silikon-Gel mit $BaAl_4$ an Luft. Eine leichte Wärmetönung ist praktisch nicht zu erkennen.

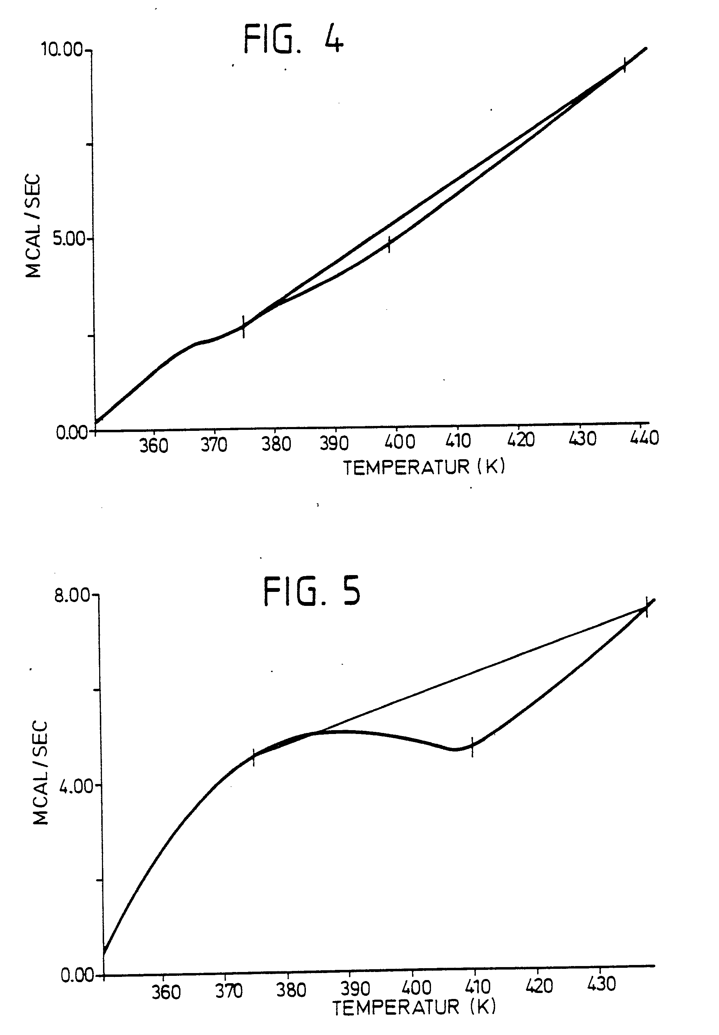

Fig. 4 zeigt ein differentialthermoanalytisches Diagramm für Silikon-Gel mit $BaAl_4$ an Luft mit Feuchtigkeit. Die Wärmetönung im Bereich von 380 °K bis 440 °K ist gut erkennbar.

Fig. 5 zeigt ein differentialthermoanalytisches Diagramm für Silikon-Gel mit $BaAl_4$ in angefeuchteter Umgebung. Die Wärmetönung im Bereich von 380 °K bis 440 °K ist stark ausgeprägt.

Bei den Versuchen nach Fig. 4 und 5 wurde eine frische Mischung verwendet.

Im folgenden werden drei Ausführungsbeispiele beschrieben.


Beispiel 1


1 g Sil-Gel-604 (Hersteller : Wacker) mit den Komponenten A und B Verhältnis 9 : 1 sowie 3 g Barium-Aluminium-Legierung in einer mittleren Korngröße von X ≤ 40 μm werden unter trockenem Stickstoffstrom gemischt, unter 1.33 Pa ($10^{-2}$ Torr) bei 23 ± 3° 5 Minuten entgast und sofort verwendet. Der Gehäusedeckel wird dünn, ca. 5-10 mg/cm², mit der Getterpaste eingestrichen. In ca. 1-2 Stunden bei Raumtemperatur bzw. in ca. 5 Minuten bei 100° ist das Getter haftfest vulkanisiert.


Beispiel 2


Die Sil-Gel-604-Komponenten A und B werden im Verhältnis 15 : 1 gemischt. Im übrigen sind die Bedingungen wie bei Beispiel 1. Infolge des Härterunterschusses bleibt das Getter gasdurchlässiger und klebriger. Es wirkt als Staubgetter bzw. zum Abfangen von störenden Teilchen.

Beispiel 3 :

Anstelle von Sil-Gel-604 wird Sil-Gel 600 und 601, die in der Wärme vulkanisiert werden, verwendet, so daß das Getter schon aktiviert ist. Selbstverständlich können auch ähnliche Produkte anderer Provenienz eingesetzt werden, z. B. die Typen von DOW CORNING :

R-4-3117
XR-90-714 (721)
Q1-9205 (Al-9214)
Q3-6527 A und B

Anstelle BaAl$_4$ wird Zirkonmetall- und Zirkonhydridpulver feinkörnig verwendet. Das ergibt noch stabilere Gasgetter.

## Patentansprüche

1. Verfahren zur Verkapselung von Mikroelektronikschaltungen mit organischen Komponenten, bei dem zur Aufnahme von korrodierenden Gasen im Innenraum als Getter feinstkörniges Pulver in einem gasdurchlässigen, inerten Silikonkautschuk dispergiert wird, dadurch gekennzeichnet, daß als Gettermaterial eine reaktive Erdalkalimetall-Aluminium-Legierung verwendet wird.

2. Mikroelektronik-Element mit organischen Komponenten, bei dem zur Aufnahme von korrodierenden Gasen im Innenraum als Getter feinstkörniges Pulver in einem gasdurchlässigen, inerten Silikonkautschuk dispergiert ist, dadurch gekennzeichnet, daß das Gettermaterial eine reaktive Erdalkalimetall-Aluminium-Legierung ist.

3. Mikroelektronik-Element nach Anspruch 2, dadurch gekennzeichnet, daß das Gettermaterial BaAl$_4$ ist.

4. Mikroelektronik-Element nach Anspruch 2 oder 3, dadurch gekennzeichnet, daß die Korngröße des Gettermaterials zwischen 0.1 und 100 $\mu$, vorzugsweise zwischen 5 und 50 $\mu$ liegt.

5. Mikroelektronik-Element nach einem der vorhergehenden Ansprüche, dadurch gekennzeichnet, daß das Gettermaterial in einem weitgehend ionenfreien (Konzentration < 50 ppm), schwach vernetzbaren, gegenüber BaAl$_4$ und den Schaltungskomponenten indifferenten Silikonkautschuk mit hohem Gaspermeationskoeffizienten, vorzugsweise einem Silikongel, dispergiert ist.

## Claims

1. A process for encapsulating microelectronic circuits with organic components, in which for the absorption of corrosive gases in the interior an extremely fine-grained powder acting as getter is dispersed in a gas-permeable inert silicon rubber, characterised in that as getter material there is employed a reactive alkaline-earth metal-aluminium alloy.

2. A microelectronic element with organic components, in which for the absorption of corrosive gases in the interior an extremely fine-grained powder as getter is dispersed in a gas-permeable inert silicon rubber, characterised in that the getter material is a reactive alkaline-earth metal-aluminium alloy.

3. A microelectronic element according to Claim 2, characterised in that the getter material is BaAl$_4$.

4. A microelectronic element according to Claim 2 or 3, characterised in that the particle-size diameter of the getter material is comprised between 0.1 $\mu$ and 100 $\mu$, preferably between 5 and 50 $\mu$.

5. A microelectronic element according to any one of the preceding Claims, characterised in that the getter material is dispersed in a substantially ion-free (< 50 ppm), weakly cross-linkable silicon rubber, preferably a silicon gel, which has a high gas-permeability coefficient and is inert relative to BaAl$_4$ and the circuit components.

## Revendications

1. Un procédé d'encapsulage de circuits de microélectronique avec des composants organiques, dans lequel une poudre très fine utilisée comme getter pour l'absorption des gaz corrosifs dans l'espace interne est dispersée dans une gomme de silicone inerte et perméable aux gaz, caractérisé par le fait que l'on utilise comme matériau getter un alliage réactif d'aluminium et d'un métal alcalino-terreux.

2. Un élément de microélectronique avec des composants organiques, dans lequel une poudre très fine utilisée comme getter pour l'absorption des gaz corrosifs dans l'espace interne est dispersée dans une gomme de silicone inerte et perméable aux gaz, caractérisé par le fait que le matériau getter est un alliage réactif d'aluminium et d'un métal alcalino-terreux.

3. Un élément de microélectronique selon la revendication 2, caractérisé par le fait que le matériau getter est BaAl$_4$.

4. Un élément de microélectronique selon la revendication 2 ou 3, caractérisé par le fait que le calibre des grains de matériau getter est compris entre 0,1 et 100 µm, de préférence entre 5 et 50 µm.

5. Un élément de microélectronique selon l'une quelconque des revendications précédentes, caractérisé par le fait que le matériau getter est dispersé dans une gamme de silicone inerte vis-à-vis de $BaAl_4$ et des composants du circuit, à fort coefficient de perméabilité aux gaz essentiellement exempte d'ions (concentration < 50 ppm), faiblement réticulable, de préférence un gel de silicone.

FIG. 1a

FIG. 1b

FIG. 1c

FIG. 1d

EP 0 200 773 B1

FIG. 2

FIG. 3

# FIG. 4

# FIG. 5

4